(19) Europäisches Patentamt / European Patent Office / Office européen des brevets

(11) **EP 2 408 283 A1**

(12) **EUROPEAN PATENT APPLICATION**

(43) Date of publication:
**18.01.2012 Bulletin 2012/03**

(51) Int Cl.:
***H05K 3/10*** (2006.01)

(21) Application number: **11172936.4**

(22) Date of filing: **06.07.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **14.07.2010 KR 20100068120**

(71) Applicant: **Korea Advanced Institute of Science and Technology**
**Daejeon 305-701 (KR)**

(72) Inventors:
• **Yang, Minyang**
**305-701 Daejeon (KR)**
• **Kang, Bongchul**
**305-701 Daejeon (KR)**

(74) Representative: **Flügel Preissner Kastel Schober**
**Patenanwälte Partnerschaft**
**Nymphenburger Strasse 20a**
**80335 München (DE)**

(54) **Method of fabricating pattern**

(57) Disclosed is a method of fabricating a pattern, and more particularly is a method of fabricating a pattern by using laser. The method includes:
a first step of forming an organometallic ink layer 20 on a substrate;
a second step of curing the organometallic ink layer 20 into a semi-solid state;
a third step of forming a pattern by irradiating laser onto the semi-solid organometallic ink layer 20, so that the irradiated portion of the organometallic ink layer 20 is changed into a solid state; and
a fourth step of leaving only the pattern by removing the semi-solid organometallic ink layer 20.

```
                    ┌─────────────┐
                    │    START    │
                    └─────────────┘
                           │
                           ▼
┌────────────────────────────────────────────────────────────────┐
│ FIRST STEP OF FORMING ORGANOMETALLIC INK LAYER ON SUBSTRATE      │
└────────────────────────────────────────────────────────────────┘
                           │
                           ▼
┌────────────────────────────────────────────────────────────────┐
│ SECOND STEP OF CURING ORGANOMETALLIC INK LAYER INTO SEMI-SOLID   │
│ STATE                                                            │
└────────────────────────────────────────────────────────────────┘
                           │
                           ▼
┌────────────────────────────────────────────────────────────────┐
│ THIRD STEP OF FORMING PATTERN BY IRRADIATING LASER ONTO          │
│ SEMI-SOLID ORGANOMETALLIC INK LAYER, SO THAT IRRADIATED          │
│ PORTION OF ORGANOMETALLIC INK LAYER IS CURED INTO SOLID STATE    │
└────────────────────────────────────────────────────────────────┘
                           │
                           ▼
┌────────────────────────────────────────────────────────────────┐
│ FOURTH STEP OF LEAVING ONLY PATTERN BY REMOVING SEMI-SOLID       │
│ ORGANOMETALLIC INK LAYER                                         │
└────────────────────────────────────────────────────────────────┘
                           │
                           ▼
                    ┌─────────────┐
                    │     END     │
                    └─────────────┘
```

**FIG. 1**

EP 2 408 283 A1

## Description

BACKGROUND OF THE INVENTION

Field of the Invention

The present invention relates to a method of fabricating a pattern, and more particularly to a method of fabricating a pattern by using laser.

Background Information

Recently, more and more demands on thinness and high performance of products of an optic industry, a display industry, a semiconductor industry and a biotechnology industry are increasing. In order to meet the demands, wires or functional thin layers which constitute each part of a product should have smaller and more uniform patterns. Therefore, a method of fabricating a fine pattern functions as bases for such industries.

In a conventional non-exposure fine patterning method, many researches are now being devoted to a LDW method using nanoparticle ink.

However, when a pattern is formed by directly irradiating laser to the nanoparticle ink having its size of several tens of nanometers, a long time for forming the pattern is required due to a large amount of solvent and a high melting point (300 ~ 400°C) of the nanoparticle. Although the nanoparticle of the nanoparticle ink can be made to be smaller, the manufacturing cost increases. For these reasons, the ink is not sintered well and resistance of a metal electrode increases.

Further, the line width of the pattern is relatively greater than the size of laser focus due to thermal diffusion of laser irradiation. A scanner cannot be used to form a pattern less than 10 $\mu$m and has a limit in fabricating fine and various patterns. Therefore, there is necessity of using an expensive objective lens capable of focusing close to diffraction limit.

Further, when laser is irradiated to liquefied ink, Marangoni flow is formed due to a surface tension gradient, so that the edge of the pattern becomes thicker and the central portion of the pattern becomes thinner. Thus, the cross section of the pattern is similarly shaped like the crater of a volcano.

To solve those problems, it is required to use transparent organometallic ink which is easy to be sintered and is sintered at a lower temperature and has a high conductivity. However, unlike the nanoparticle ink, the organometallic ink is transparent because it generally does not include metal particles therein. Therefore, absorptance of the laser is low, so that patterning does require more light energy and the line width of the pattern increases.

SUMMARY OF THE INVENTION

A pattern fabrication method related to claim 1 includes a first step of forming an organometallic ink layer 20 on a substrate; a second step of curing the organometallic ink layer 20 into a semi-solid state; a third step of forming a pattern by irradiating laser onto the semi-solid organometallic ink layer 20, so that the irradiated portion of the organometallic ink layer 20 is changed into a solid state; and a fourth step of leaving only the pattern by removing the semi-solid organometallic ink layer 20.

Therefore, according to the pattern fabrication method related to claim 1, since the organometallic ink layer 20 is changed into the semi-solid state, light absorptance of the organometallic ink is improved and the thermal diffusion is reduced at the time of irradiating the laser, thereby easily forming a fine pattern. Further since the organometallic ink layer is changed into the semi-solid state, Marangoni flow effect becomes weaker and hydrodynamic flow effect becomes stronger. Accordingly, there are advantages in that it is possible to form the pattern having a uniform thickness and to improve the conductivity due to the increased thickness of the pattern. Further, since a thermal diffusion distance by the laser irradiation becomes short, the patterning can be done with a low-power laser at a high speed.

Further, since the organometallic ink is sintered at a lower temperature, the pattern fabrication method can be applied to a flexible substrate. Moreover, since the organometallic ink is inexpensive, the pattern can be fabricated at a low cost.

In the pattern fabrication method of claim 1, a pattern fabrication method related to claim 2 includes the second step of curing the organometallic ink layer 20 into a semi-solid state by heating with a heat lamp the substrate including the organometallic ink layer 20 formed thereon.

Therefore, according to the pattern fabrication method related to claim 2, light absorptance of the organometallic ink is increased, and the thermal diffusion is reduced at the time of irradiating the laser, thereby easily forming a fine pattern. Further since the organometallic ink layer is changed into the semi-solid state, Marangoni flow effect becomes weaker. Accordingly, there are advantages in that it is possible to form the pattern having a uniform thickness. Further, the patterning can be done with a low-power laser at a high speed. Further, it is possible to perform a continuous process and heat at a uniform temperature.

In the pattern fabrication method of claim 1, a pattern fabrication method related to claim 3 includes the second step of curing the organometallic ink layer 20 into a semi-solid state by heating with a hot plate or a convection oven the substrate including the organometallic ink layer 20 formed thereon.

Therefore, according to the pattern fabrication method related to claim 3, light absorptance of the organometallic ink is increased, and the thermal diffusion is reduced at the time of irradiating the laser, thereby easily forming a fine pattern. Further since the organometallic ink layer is changed into the semi-solid state, Marangoni flow effect becomes weaker. Accordingly, there are advantages in that it is possible to form the pattern having a uniform thickness. Further, the patterning can be done with a low-power laser at a high speed. Further, it is possible to heat by setting and maintaining a desired temperature.

In the pattern fabrication method of claim 1, a pattern fabrication method related to claim 4 includes the fourth step of leaving only the pattern through the removal of the semi-solid organometallic ink layer 20 by immersing the substrate in a cleaning solution, or by performing ultrasonic cleaning on the substrate or by injecting the cleaning solution to the substrate.

Therefore, according to the pattern fabrication method related to claim 4, since a portion of the organometallic ink layer, onto which the laser is not irradiated, is not removed by the cleaning solution, only the changed solid pattern can remain on the substrate.

In the pattern fabrication method of claim 1, a pattern fabrication method related to claim 5 includes the fourth step of heating the substrate including the pattern formed thereon.

Therefore, according to the pattern fabrication method related to claim 5, since the substrate including the pattern formed thereon is heated, the conductivity of the pattern can be improved by removing the residue which remains on the substrate. Also, the pattern can be changed again and dried by removing organic solvent penetrating the pattern. Consequently, the pattern is more surely sintered, so that the completeness of the substrate can be improved.

BRIEF DESCRIPTION OF THE DRAWINGS

The above and other features and advantages of the present invention will become more apparent to those of ordinary skill in the art by describing in detail preferred embodiments thereof with reference to the attached drawings, in which:

Fig. 1 shows a flowchart of a pattern fabrication method of claim 1.

Fig. 2 shows a series of procedure of fabricating the pattern.

Fig. 3 shows variations of the thickness and absorbance (at 532 nm) of coated organometallic ink with the pre-baking time.

Fig. 4 shows statistical analysis of self-generated Ag nanoparticle size distribution and the corresponding a transmission electron microscope(TEM) image after pre-baking for 90 sec.

Fig. 5 shows that the edge of the pattern becomes thicker and the central portion of the pattern becomes thinner due to Marangoni flow.

Fig. 6 is a cross sectional view of the pattern obtained by performing a laser patterning on nanoparticle ink.

Fig. 7 is a view for describing Marangoni flow.

Fig. 8 shows that the thickness of the pattern becomes uniform due to hydrodynamic flow.

Fig. 9 is a view for describing hydrodynamic flow.

Fig. 10 shows a method of fabricating a pattern by using galvanometer scanning.

Fig. 11 shows a method of fabricating a pattern by using a contact mask.

Fig. 12 shows a method of fabricating a pattern by using mask projection.

Fig. 13 shows a method of fabricating a pattern by using a spatial light modulator (SLM).

Fig. 14a shows pattern width dependence on the laser power ($\lambda$ = 1070 nm) and the scan rate (spin coated at 1000 rpm and a pre-baking time of 90 sec).

Fig. 14b shows AFM profile and image of a laser changed silver line pattern (spincoated at 1000 rpm, 200 mW laser power, 25 mm/s scan rate).

Fig. 14c shows 2D AFM surface roughness images and corresponding profile of laser changed pattern.

Fig. 14d shows E-beam evaporated pattern.

DETAILED DESCRIPTION OF THE PREFERRED EMBODIMENTS

Hereafter, an embodiment of the present invention will be described in detail with reference to accompanying drawings. However, the accompanied drawings are provided only for more easily describing the present invention. It is easily understood by those skilled in the art that the spirit and scope of the present invention is not limited to the scope of the accompanied drawings. The features, advantages and method for accomplishment of the present invention will be more apparent from referring to the following detailed embodiments described as well as the accompanying drawings. The same reference numerals throughout the disclosure correspond to the same elements. Marangoni flow and hydrodynamic flow are needed to describe both the problems of a conventional method of fabricating a pattern and the effect of the present invention, and will be successively mentioned. Here, the Marangoni flow and hydrodynamic flow will be collectively described after all of the claims are described.

See a treatise「Bongchul Kang, Seunghwan Ko, Jongsu Kim and Minyang Yang*, "Microelectrode fabrication by laser direct curing of tiny nanoparticle self-generated from organometallic ink," 31 January 2011/Vol. 19, No. 3/OPTICS EXPRESS 2573~2579.」for more understanding of the present invention.

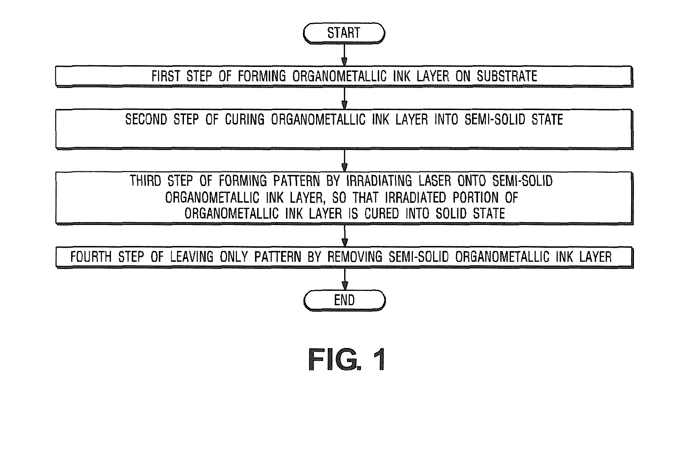

Fig. 1 shows a flowchart of a pattern fabrication method. Referring to Fig. 1, The pattern fabrication method of the present invention includes a first step of forming an organometallic ink layer 20 on a substrate 10, a second step of curing the organometallic ink layer 20 into a semi-solid state, a third step of forming a pattern 21 by irradiating laser onto the semi-solid organometallic ink layer 20, so that the irradiated portion of the organometallic ink layer 20 is changed into a solid state, and a fourth step of leaving only the pattern 21 by removing the semi-solid organometallic ink layer 20.

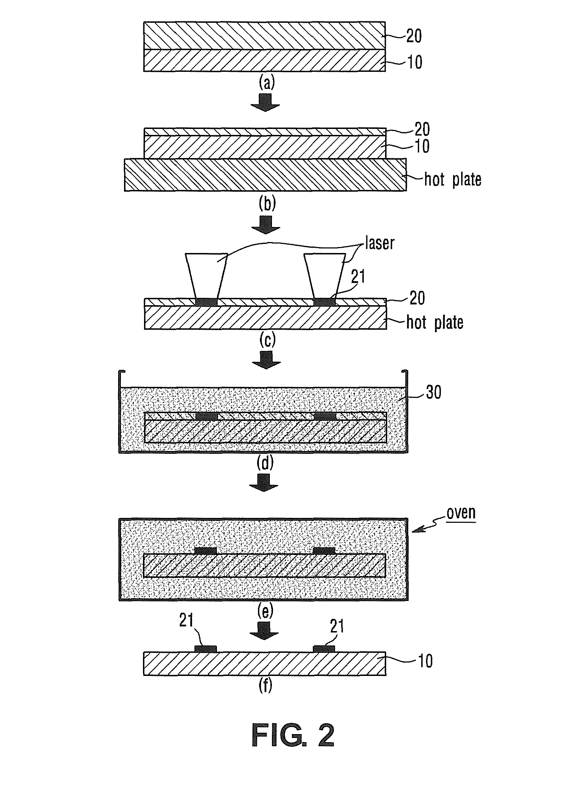

Fig. 2 shows a series of procedure of fabricating the pattern. A method of fabricating the pattern will be described with reference to Figs. 1 and 2.

The first step is to form the organometallic ink layer 20 on the substrate 10. That is, liquid organometallic ink is coated on a hard substrate like glass (hereafter, referred to as a substrate 10) (S100). Therefore, a lower layer represents the substrate 10 in (a) of Fig. 2, and an upper layer represents the organometallic ink layer 20 formed on the substrate 10. Here, the method of forming the organometallic ink layer 20, which is used in the first step, includes a spin coating method, a blading coating method, a spray method, an ink jet method and a roll-to-roll method and the like.

The second step is to change the organometallic ink layer 20 into a semi-solid state (S200). Any method will be used as long as it can change the organometallic ink layer 20 into a semi-solid state. The semi-solid state refers to a state where the organometallic ink has higher fluidity than that of a completely changed solid and has much lower fluidity than that of a liquid flowing along an inclined surface. The solid state also refers to a state where the organometallic ink maintains its more or less transformed shape without being broken when a force greater than a predetermined force is applied to the organometallic ink. The solid state also refers to a state where solid particles start to be formed within the organometallic ink by a reduction reaction. The semi-solid organometallic ink is thinner than the liquid organometallic ink because an organic solvent 23 constituting most of the organometallic ink is evaporated when the organometallic ink changes into the semi-solid state from the liquid state. Here, the organometallic ink layer 20 should not be in a solid state caused by complete evaporation of the organic solvent, and should be in a semi-solid state caused by the evaporation of the most of the organic solvent.

In the embodiment for describing the present invention, the organometallic ink is transparent. Most of laser having a specific wavelength which is used to perform patterning on the transparent organometallic ink transmit through the transparent organometallic ink. Therefore, since only a small amount of light energy remaining after the laser transmits through the transparent organometallic ink is used in the patterning, high-power laser had to be used for patterning. Moreover, in a conventional patterning method, since ink based on the organic solvent 23 is thickly coated on the substrate 10 and laser is irradiated onto the thick ink, the width of the pattern is wide not narrow. On the other hand, in the present invention, laser is not irradiated as soon as the transparent organometallic ink is applied on the substrate 10, but is irradiated in a state where the organometallic ink layer 20 becomes thin due to the volatilization of the organic solvent 23 constituting most of the transparent organometallic ink. Accordingly, there is an advantage in that the pattern 21 can be formed thin.

In the present invention, after performing the second step, the color of the transparent organometallic ink is turned into brown. As described above, most of the laser used for patterning transmit through the transparent organometallic ink. Contrarily, the laser absorptance of the brown organometallic ink becomes larger than that of the transparent organometallic ink. Consequently, the transmittance is remarkably reduced. Accordingly, this means that the efficiency of laser patterning of the organometallic ink is improved. As a result, since the organometallic ink is brown, not transparent, and is in a semi-solid state, not a liquid state, light absorptance of the organometallic ink overall increases when laser is irradiated onto the transparent organometallic ink layer 20. Since a large amount of the organic solvent 23 within the organometallic ink, more accurately speaking, the organic solvent 23 which is not M-C bonded is removed by heating the substrate 10, the thermal diffusion is reduced at the time of irradiating the laser, thereby easily forming a fine pattern 21. Further, since a thermal diffusion distance for forming the pattern 21 is short, the patterning can be done with a low-power laser at a high speed.

As described above, in the pattern fabrication method of the present invention, the transparent organometallic ink is used. Particularly, a case where transparent organometallic Ag ink including Ag among metal materials is used will be described as an example. The organometallic Ag ink is made by dissolving Ag ions in the organic solvent and is in a transparent liquid state at a normal temperature. Here, though Ag is used, other metal materials such as copper having high conductivity, and Au and the like can be used. The organometallic Ag ink will be additionally described in detail in the second step.

In the second step, the organometallic Ag ink is heated and the Ag ion is reduced simultaneously with the evaporation of the organic solvent, and then the Ag ion is reduced and extracted into a solid metal. It should be noted that the Au ion included in the ink is extracted into a solid metal and that the ink itself does not enter a solid state. As already mentioned, the ink itself is in a semi-solid state. The organometallic Ag ink has a low sintering temperature of 150°C to 200°C unlike the nanoparticle ink.

In general, a flexible substrate is made of a polymer material, for example, a PI film. Such a polymer material is mostly melted away at a temperature of about 350°C. Heat of a temperature of 300°C to 400°C is required to sinter the liquid nanoparticle ink. Although Ag is made in a state of the nanoparticle, heat of a temperature of 300°C to 400°C is required to sinter the Ag in the state of the nanoparticle. Therefore, it was generally difficult to apply a patterning method using the conventional nanoparticle ink to the flexible substrate. Nanoparticle ink including particles finer than the particles of the conventional nanoparticle ink has a low sintering temperature so that it can be applied to the flexible substrate.

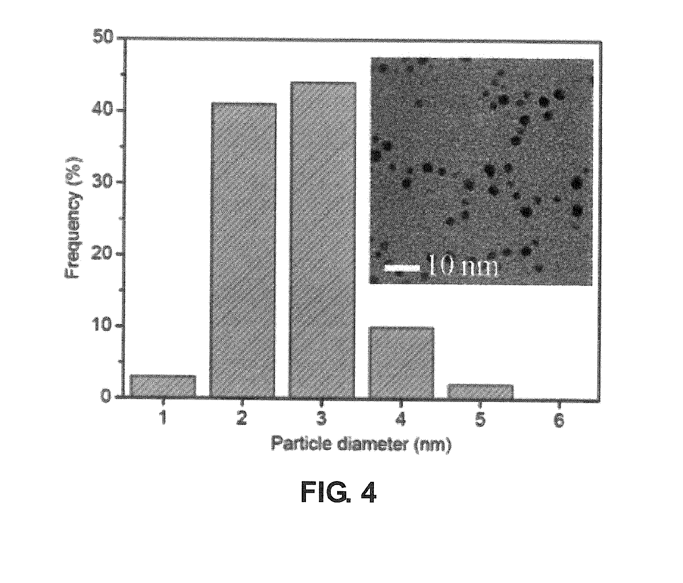

However, the unit price of the ink rapidly rises so that the ink is limited or is difficult to be applied to a production system. Contrarily to this, the Ag ion of the organometallic Ag ink is reduced into the nanoparticle and then becomes a solid Ag particle. Here, since the size of the reduced nanoparticle is smaller than that of the particle of a common nanoparticle ink, light absorptance thereof increases and the organometallic Ag ink is easy to be sintered at a low temperature. As a result, since the ink is sintered at a low temperature, the patterning method of the present invention can be applied to the flexible substrate. Nanoparticle size distribution will be described in the following Fig. 4.

Through the second step, the amount of the metallic particles which is reduced within the semi-solid organometallic ink is increased so that solid metal particles are present within the organometallic ink. Therefore, when laser is irradiated onto the organometallic ink layer 20 in the third step, the organometallic ink is able to better absorb the laser. Accordingly, more thermal diffusion is reduced at the time of irradiating the laser, thereby easily forming a fine pattern 21. Further, since a thermal diffusion distance for forming the pattern 21 becomes shorter, the patterning can be done with a low-power laser at a higher speed. Moreover, because the ink is inexpensive, the fabricating cost of the pattern 21 is low.

The third step is to form the pattern 21 by irradiating laser onto the semi-solid organometallic ink layer 20, so that the irradiated portion of the organometallic ink layer 20 is changed into a solid state (S300). Continuous wave laser or pulsed laser can be used as the laser in the third step in accordance with the properties of a transfer material and the substrate 10. The laser is irradiated onto a position where the pattern 21 is expected to be formed in the organometallic ink layer 20, and then the irradiated position ischanged into a semi-solid state. The third step will be described with reference to (c) of Fig. 2. It is shown in (c) of Fig. 2 that the position irradiated by the laser is formed as the pattern 21 by using a negative approach. Here, when the second step is completed, the organometallic ink layer 20 is in a semi-solid state. Before the entire organometallic ink layer 20 ischanged, the organometallic ink layer 20 is locally selectively changed by the laser. Here, the change is controlled through the power of the laser, laser feed rate, the size of the laser beam and the like.

The fourth step is to leave only the pattern 21 by removing the semi-solid organometallic ink layer 20 (S400). When the semi-solid organometallic ink layer 20 is removed except for the organometallic ink layer 20 of which a predetermined area has been changed into a solid state and corresponds to the pattern 21, only the solid pattern 21 remains on the substrate 10. (f) of Fig. 2 shows the substrate 10 including the completed pattern 21 after the completion of the fourth step.

The second step will be described in more detail in the following description. The pattern fabrication method includes the first step of forming the organometallic ink layer 20 on the substrate 10, the second step of curing the organometallic ink layer 20 into a semi-solid state by heating with a heat lamp the substrate 10 including the organometallic ink layer 20 formed thereon, the third step of forming the pattern 21 by irradiating laser onto the semi-solid organometallic ink layer 20, so that the irradiated portion of the organometallic ink layer 20 is changed into a solid state, and the fourth step of leaving only the pattern 21 by removing the semi-solid organometallic ink layer 20.

Referring go Figs. 1 and 2, the second step will be described in more detail. The substrate 10 on which the organometallic ink layer 20 has been formed is heated by a heat lamp. An example of a method of heating the substrate 10 on which the organometallic ink layer 20 has been formed is shown in (b) of Fig. 2. While it is shown that the substrate 10 is heated by a hot plate, it can be easily understood by those skilled in the art that the substrate 10 on which the organometallic ink layer 20 has been formed can be heated by using radiant heat through the heat lamp. In the second step of the pattern fabrication method, in order to change the organometallic ink layer 20 into a semi-solid state, most of the organic solvent 23 of the organometallic ink layer 20 applied on the substrate 10 is evaporated by heating with the heat lamp the substrate 10 on which the organometallic ink layer 20 has been formed. The heat lamp heats by using the radiant heat. Through this method, it is difficult to heat by setting and maintaining a desired temperature. However, as compared with a method to be described below of heating by a hot plate or a convention oven, this method is advantageous for performing a continuous process and heating at a uniform temperature.

From now on, the second step will be described in more detail in the following description. The pattern fabrication method includes the first step of forming the organometallic ink layer 20 on the substrate 10, the second step of curing the organometallic ink layer 20 into a semi-solid state by heating with a hot plate or a convection oven the substrate 10 including the organometallic ink layer 20 formed thereon, the third step of forming the pattern 21 by irradiating laser onto the semi-solid organometallic ink layer 20, so that the irradiated portion of the organometallic ink layer 20 is changed into a solid state, and the fourth step of leaving only the pattern 21 by removing the semi-solid organometallic ink layer 20.

Referring go Figs. 1 and 2, the second step will be described in more detail. The substrate 10 on which the organometallic ink layer 20 has been formed is heated by a hot plate or a convection oven. An example of a method of heating the substrate 10 on which the organometallic ink layer 20 has been formed is shown in (b) of Fig. 2. It is shown that the substrate 10 is heated by the hot plate. In the second step of the pattern fabrication method, in order to change the organometallic ink layer 20 into a semi-solid state, most of the organic solvent 23 of the organometallic ink layer 20 applied on the substrate 10 is evaporated by heating with the hot plate or the convection oven the substrate 10 on which the organometallic ink layer 20 has been formed. The hot plate heats the substrate 10 by using conduction. The convection oven heats the substrate 10 by using convection current. Through this method, it is difficult to perform a continuous process and to heat at a uniform temperature. However, as compared with the method of heating by the heat lamp using the radiant heat, this method is advantageous for heating by setting and maintaining a desired temperature.

From now on, the fourth step will be described in more detail in the following description. The pattern fabrication method of the present invention includes the first step of forming the organometallic ink layer 20 on the substrate 10, the second step of curing the organometallic ink layer 20 into a semi-solid state, the third step of forming the pattern 21 by irradiating laser onto the semi-solid organometallic ink layer 20, so that the irradiated portion of the organometallic ink layer 20 is changed into a solid state, and a fourth step of leaving only the pattern 21 through the removal of the semi-solid organometallic ink layer 20 by immersing the substrate 10 in a cleaning solution 30, or by performing ultrasonic cleaning on the substrate 10 or by injecting the cleaning solution 30 to the substrate 10.

The description thereof will be provided with reference to Figs. 1 and 2. Referring to (d) of Fig. 2, it is shown that a part of the organometallic ink layer 20 corresponds to the changed pattern 21, and the other part of the organometallic ink layer 20 is formed into a semi-solid state on the substrate 10, and the substrate 10 is immersed in the cleansing solution contained in a vessel. Fig. 2 shows only a process of removing the semi-solid organometallic ink layer 20 by immersing the substrate 10 in the cleaning solution 30. Besides, the fourth step of the pattern fabrication method also includes a process of removing the semi-solid organometallic ink layer 20 by performing ultrasonic cleaning on the substrate 10 or by injecting the cleaning solution 30 to the substrate 10. It is regarded that any process among the processes mentioned above is included in the fourth step of the pattern fabrication method. Further, it can be easily understood by those skilled in the art that the ink layer 20 except for the pattern 21 is removed by performing ultrasonic cleaning or by injecting the cleaning solution 30.

Here, the organic solvent for removing the semi-solid organometallic ink layer 20 includes, for example, the organic solvent 23 which is the base of the organometallic Ag ink, or acetone, nucleic acid or IPA and the like. In the fourth step, the ink layer except for the formed pattern 21 is cleared away by using the organic solvent. Generally, the whole substrate 10 on which the pattern 21 has been formed is immersed in the vessel containing the organic solvent 23 which is the base of the organometallic Ag ink, or acetone, nucleic acid or IPA and the like. Therefore, only the changed solid pattern 21 remains on the substrate 10. The ultrasonic cleaning method is to give an ultrasonic wave to the substrate 10 immersed in the cleaning solution 30. The method of injecting the cleaning solution 30 is to leave only the pattern 21 by directly injecting the cleaning solution 30 to the substrate 10 in the form of a spray.

From now on, the fourth step will be described in more detail in the following description. The pattern fabrication method of the present invention includes the first step of forming the organometallic ink layer 20 on the substrate 10, the second step of curing the organometallic ink layer 20 into a semi-solid state, the third step of forming the pattern 21 by irradiating laser onto the semi-solid organometallic ink layer 20, so that the irradiated portion of the organometallic ink layer 20 is changed into a solid state, and a fourth step of leaving only the pattern 21 through the removal of the semi-solid organometallic ink layer 20 by immersing the substrate 10 in the cleaning solution 30, or by performing ultrasonic cleaning on the substrate 10 or by injecting the cleaning solution 30 to the substrate 10, and then heating the substrate 10.

The pattern fabrication method will be described with reference to Figs. 1 and 2. Referring to (e) of Fig. 2, it is shown that the substrate 10 on which only the pattern 21 remains is placed and heated in an oven. This shows an example of heating the substrate 10. Not only the semi-solid organometallic ink layer 20 is removed by immersing the substrate 10 in the cleaning solution 30, or by performing ultrasonic cleaning on the substrate 10 or by injecting the cleaning solution 30 to the substrate 10, but also the substrate 10 is additionally heated.

If the substrate 10 is cleaned only in the fourth step, the organic solvent penetrates the changed pattern 21 during the cleaning of the substrate 10 so that the pattern 21 may be liquefied again. Therefore, the substrate 10 is additionally heated in order to change again or dry the pattern 21. This intends to firmly sinter the pattern 21. Although the step of additionally heating the substrate 10 is not necessary to form the pattern 21 on the substrate 10, the step of additionally heating the substrate 10 is necessary for improving the completeness of the substrate 10 including the pattern 21 formed thereon, for example, after the semi-solid organometallic ink layer 20 except for the pattern 21 is cleared away by the cleaning solution 30, the residue of the organic solvent which remains on the substrate 10 is removed and the conductivity of the pattern 21 is improved.

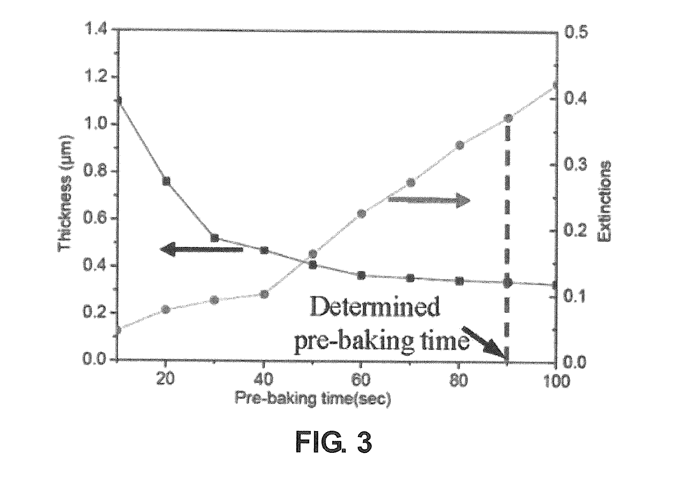

Fig. 3 shows variations of the thickness and absorbance (at 532 nm) of coated organometallic ink with the pre-baking time. The semi-solid state refers to a state where the organometallic ink has higher fluidity than that of a completely changed solid and has much lower fluidity than that of a liquid flowing along an inclined surface. The transient change of those values of the organometallic ink was measured at various pre-baking time after spin-coating at 1000 rpm on a soda-lime glass. A baking temperature of 100 °C was carefully determined to acquire a uniform thickness and to avoid the agglomeration of nanoparticles in preliminary experiments since the excessive increase of the baking temperature causes the spatial gradient of the pre-baked ink thickness. The thickness converged to approximately 0.33 $\mu$m after 60 sec pre-baking while the optical absorption increased linearly with the pre-baking time. The optical absorption increase signifies the generation of nanoparticles from the organometallic ink.

Fig. 4 shows statistical analysis of self-generated Ag nanoparticle size distribution and the corresponding a transmission electron microscope(TEM) image after pre-baking for 90 sec. Despite a short thermal pre-baking below the sintering temperature, Ag nanoparticles start to nucleate uniformly without agglomeration. The statistical analysis on the nanoparticle size distribution after pre-baking for 90 sec was conducted by TEM images. 88% of Ag nanoparticles have a diameter below 3 nm and the average particle size is 2.54 nm with the standard deviation of 0.67 nm. It is clear that the uniform Ag nanoparticles of 2~3 nm were self-generated inside the residual silver/organic complexes. As expected, it can be estimated that such tiny nanoparticles were generated by the mild decomposition of the complexes and mild growth of the Ag nanoparticles.

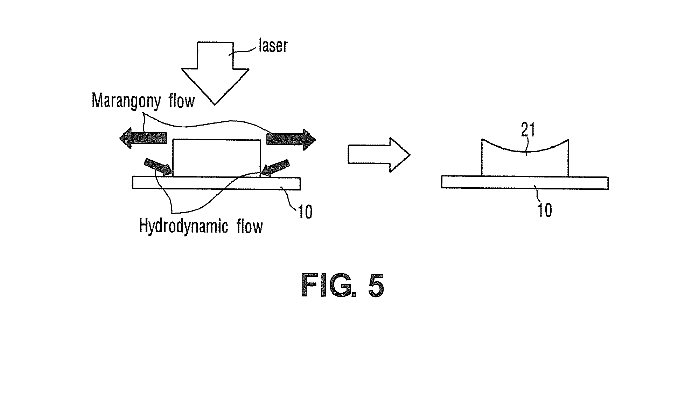

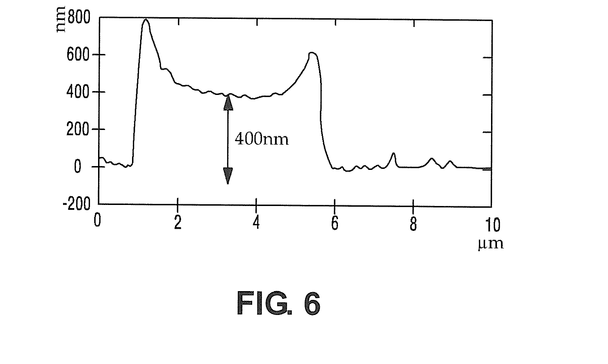

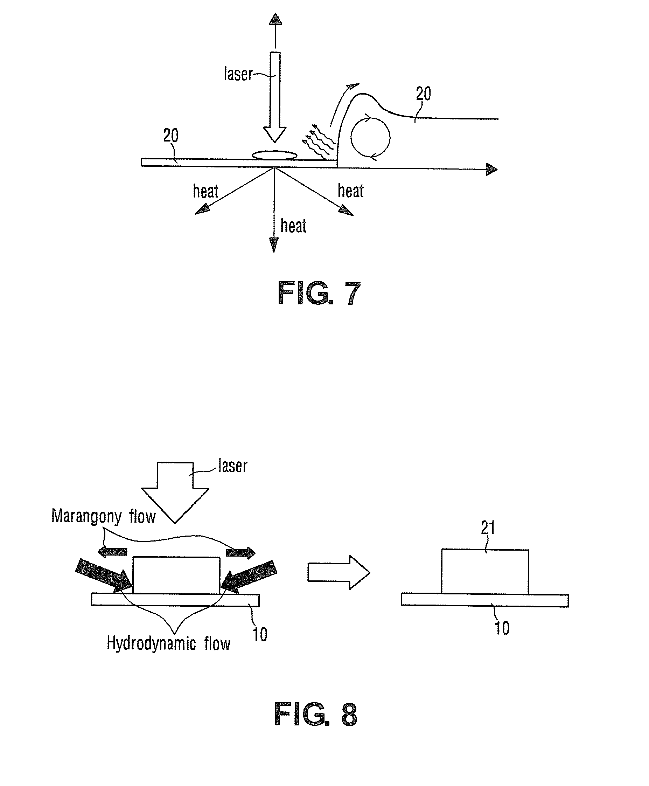

Fig. 5 shows that the edge of the pattern becomes thicker and the central portion of the pattern becomes thinner due to Marangoni flow. Fig. 6 is a cross sectional view of the pattern obtained by performing a laser patterning on nanoparticle ink. Fig. 7 is a view for describing Marangoni flow.

The Marangoni flow effect in the patterning using the conventional nanoparticle ink will be described with reference to Figs. 5 to 7. The figure on the left of Fig. 5 shows a force acting on the ink applied on the substrate 10. The figure on the right of Fig. 5 shows a cross section shape of the pattern 21 formed by the force action. In the left figure of Fig. 5, two arrows pointing outward from the upper portion of the ink represent Marangoni flow force. Two arrows pointing from the lower portion of the ink toward the center of the ink represent a hydrodynamic flow force. The two forces are proportional to the sizes of the arrows. The hydrodynamic flow will be described again later.

When laser is irradiated downward onto the ink on the substrate 10 shown in Fig. 5, the laser is not uniformly irradiated onto the ink, and the temperature of the central portion of the laser becomes higher than those of the other portions of the laser. Therefore, the central portion of the ink is more evaporated than the edge portion of the ink. Here, it is the organic solvent that is mainly evaporated. In this case, the edge portion of the ink, onto which the laser is weakly irradiated, has a surface tension greater than that of the central portion of the ink, onto which the laser is strongly irradiated. Therefore, a flow is created from a position having a high surface tension to a position having a low surface tension, and eventually the cross section of the patternized ink is shaped like the crater of a volcano. Such a shape is formed by Marangoni flow. Although the hydrodynamic flow force acts on a portion on which the substrate 10 and the ink contact with each other, the hydrodynamic flow force is less than the Marangoni flow force and has little influence on the formation of the ink. Consequently, the Marangoni flow force dominantly acts on the ink. Accordingly, as shown in the figure on the right of Fig. 5, the central portion of the pattern 21 is depressed. Such a shape causes coating ununiformity in coating another material on the pattern 21 in the future and degrades the conductivity.

Fig. 6 shows specific numerical values of the pattern 21 of which the central portion is depressed. It can be found that the central portion of the pattern 21 obtained by performing laser patterning on the nanoparticle ink has a thickness of 400 nm, and the edge portion of the pattern 21 has a thickness of about 600 nm to 800 nm. This is just an example of a certain case. There may be present any pattern 21 having both a volcano crater shaped cross section similarly to that of Fig. 6 and different numerical values.

Referring to Fig. 7, the Marangoni flow will be described in more detail. Since the laser is irradiated downward onto the ink and the temperature of the central portion of the laser is high, heat is diffused around the portion of the ink, onto which the central portion of the laser is irradiated. The organic solvent 23 is evaporated by the heat. In Fig. 7, squiggly arrows represent that the organic solvent 23 is evaporated. Subsequently, since the portion of the ink, which is apart from the central portion of the laser, has a surface tension greater than that of the portion of the ink, onto which the central portion of the laser is irradiated, surface tension gradient is generated. Accordingly, a flow that the ink moves from the portion of the ink, onto which the central portion of the ink is irradiated, to the portion of the ink, which is apart from the central portion of the laser, is created. The flow is referred to as the Marangoni flow. The Marangoni flow causes the edge portion of the pattern 21 to be thicker and the central portion of the pattern 21 to be thinner.

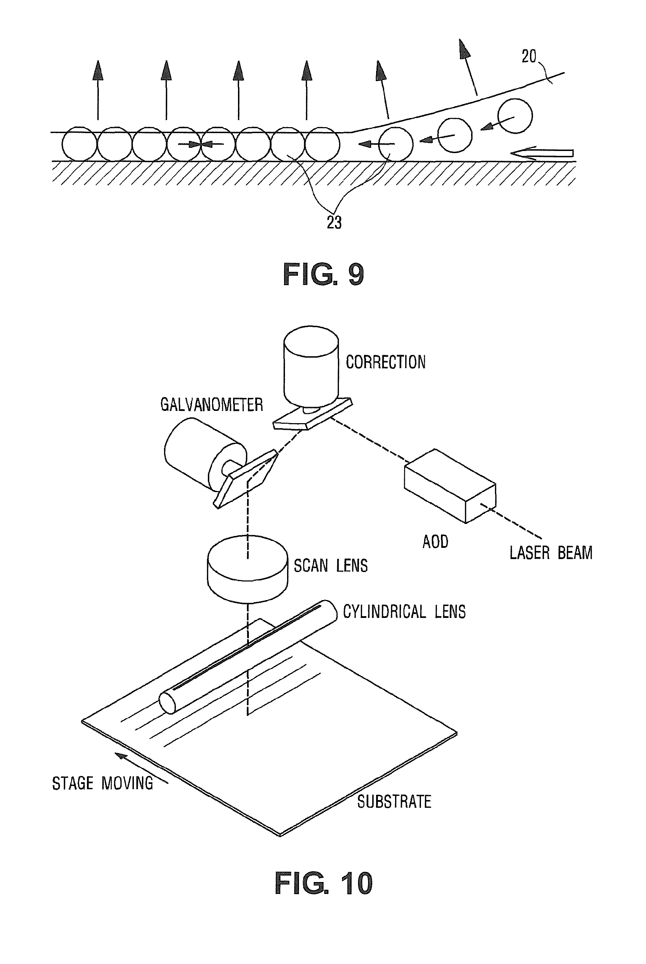

Fig. 8 shows that the thickness of the pattern becomes uniform due to hydrodynamic flow. Fig. 9 is a view for describing hydrodynamic flow. Fig. 8 will be compared with Fig. 5 for easily understanding the following description. The figure on the left of Fig. 5 shows a force acting on the ink applied on the substrate 10. The figure on the right of Fig. 5 shows a cross section shape of the pattern formed by the force action. In the left figure of Fig. 5, two arrows pointing outward from the upper portion of the ink represent the Marangoni flow force. Two arrows pointing from the lower portion of the ink toward the center of the ink represent the hydrodynamic flow force. The two forces are proportional to the sizes of the arrows. Fig. 8 shows the pattern 21 formed through patterning by using the transparent organometallic ink. Unlike the Fig. 6, although the hydrodynamic flow force acts on the ink, the hydrodynamic flow force dominantly acts on the ink. Therefore, the thickness of the pattern 21 is uniform from the edge portion thereof to the central portion thereof.

Fig. 9 is a view for describing hydrodynamic flow. Arrows pointing upward represent that the organic solvent 23 is evaporated. As described above, since the central portion of the laser has higher energy and a higher temperature, the organic solvent 23 of the portion of the ink, onto which the central portion of the laser is irradiated, is more volatilized. The left portion of Fig. 9 shows the central portion of the pattern 21, onto which the central portion of the laser is irradiated. The right portion of Fig. 9 shows the edge portion of the pattern 21. Referring to Fig. 9, since the height of the organic solvent 23 of the central portion of the pattern 21 is less than that of the organic solvent 23 of the edge portion of the pattern 21, a flow that the organic solvent 23 moves from the edge portion of the pattern 21 to the central portion of the pattern 21 is created in order to equalize the heights of the central portion and the edge portion of the organic solvent 23. The flow transfers the reduced solid metal particles to the central portion of the pattern 21. Eventually, the solid metal particles gather to the portion on which the pattern 21 is expected to be formed, so that the pattern 21 can be formed thin. The hydrodynamic flow is also present in the patterning using the nanoparticle ink. In the figure on the left of Fig. 5, the hydrodynamic flow is represented by two small arrows. However, the size of the nanoparticle is too large to move depending on the flow of the organic solvent 23. Besides, the hydrodynamic flow has little influence on the nanoparticles due to the interaction force between the nanoparticles.

The principles of the Marangoni flow and hydrodynamic flow have been described with reference to Figs. 5 to 9. Also, the steps of the pattern fabrication method using the laser, particularly, the second and the third steps can be more clearly understood. In the pattern fabrication method, when the laser is irradiated onto the nanoparticle ink, the Marangoni flow effect becomes stronger and the hydrodynamic flow effect becomes weaker. When the laser is irradiated onto the semi-solid organometallic ink, the Marangoni flow effect becomes weaker and the hydrodynamic flow effect becomes stronger. Accordingly, there are advantages in that it is possible to form the pattern 21 having a uniform thickness and to improve the conductivity due to the increased thickness of the pattern 21.

Meanwhile, in the pattern fabrication method described above, a laser irradiation method includes the following methods of Figs. 10 to 13.

Fig. 10 shows a method of fabricating a pattern by using galvanometer scanning. Referring to Fig. 10, a laser beam passes through an advanced optical disk (AOD), a correction, a galvanometer, a scan lens and a cylindrical lens in the order listed, and then transmits through a substrate. Here, the pattern is formed by moving the substrate instead of the laser beam. This method provides fast scanning at a speed equal to or more than 10m/s.

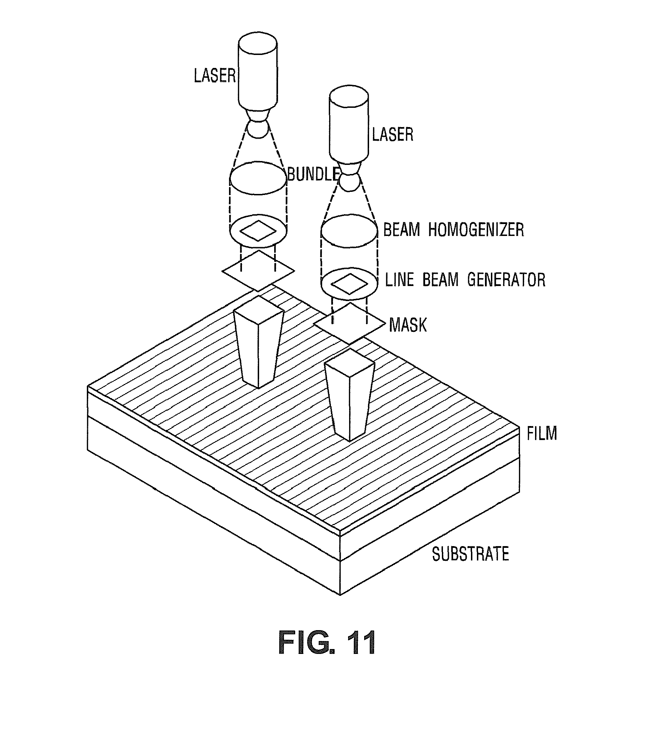

Fig. 11 shows a method of fabricating a pattern by using a contact mask. Referring to Fig. 11, when a laser beam passes through a bundle, a homogenizer and a line beam generator in the order listed, a multi homogenized line beam is generated. Then, the multi homogenized line beam is coated on a substrate and a mask directly contacts with the substrate, and then the beam is one-to-one projected. A scanning having low accuracy can be used by this method.

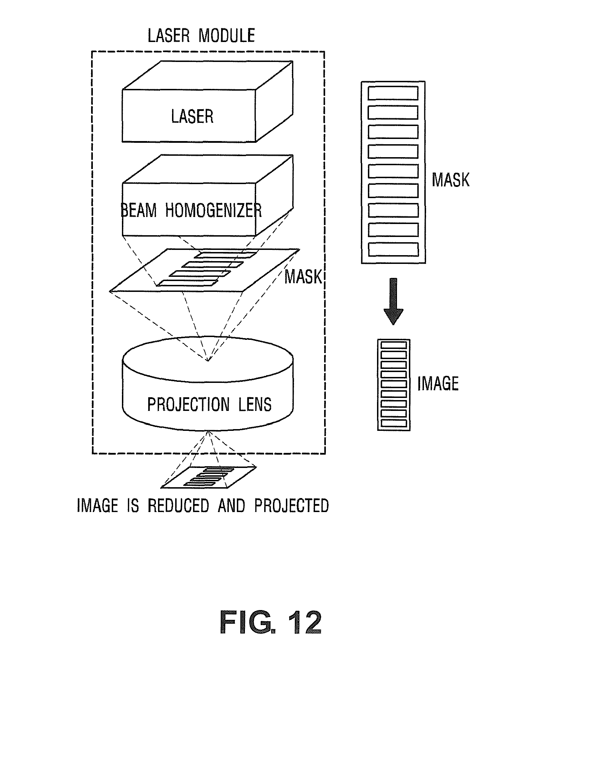

Fig. 12 shows a method of fabricating a pattern by using mask projection. Referring to Fig. 12, when a laser beam passes through a beam homogenizer, a shaping and a mask in the order listed, a shaped beam passes through a projection lens, and then an image is reduced and projected according to a distance between the mask and the projection lens. The pattern fabrication method using the mask projection is different from the pattern fabrication method using the contact mask in that the pattern fabrication method using the mask projection irradiates laser from the mask to a projection optical system while the pattern fabrication method using the contact mask irradiates laser from the projection optical system to the mask.

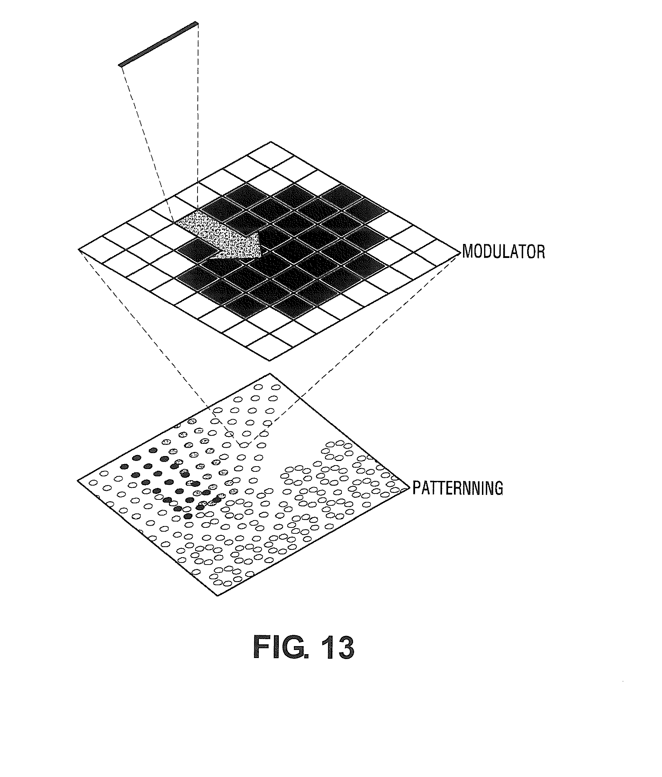

Fig. 13 shows a method of fabricating a pattern by using a spatial light modulator (SLM). Referring to Fig. 13, the SLM is a modulator which spatially variously changes light. When light passes through the modulator, the light is changed into particularly shaped light. The patterning is performed by using the particularly shaped light. The SLM is controlled by a computer. Therefore, there is no necessity of the mask and the patterning can be easily performed according to light having a desired shape.

Further, not only the aforementioned four laser irradiation methods but also another laser irradiation method can be used.

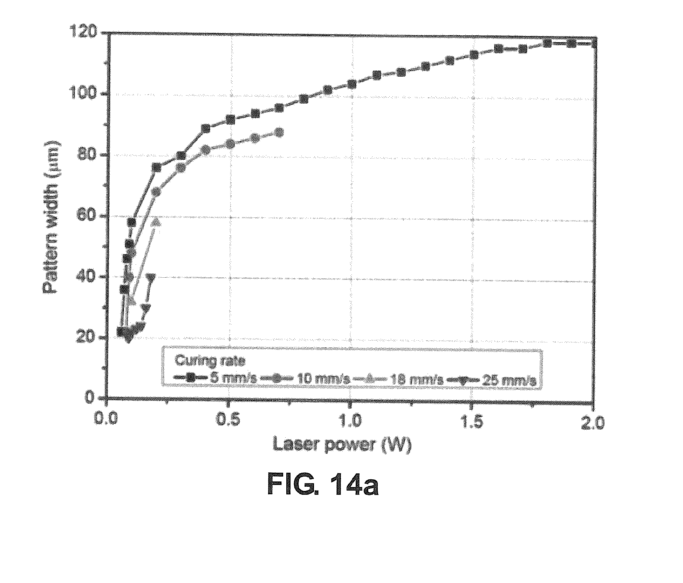

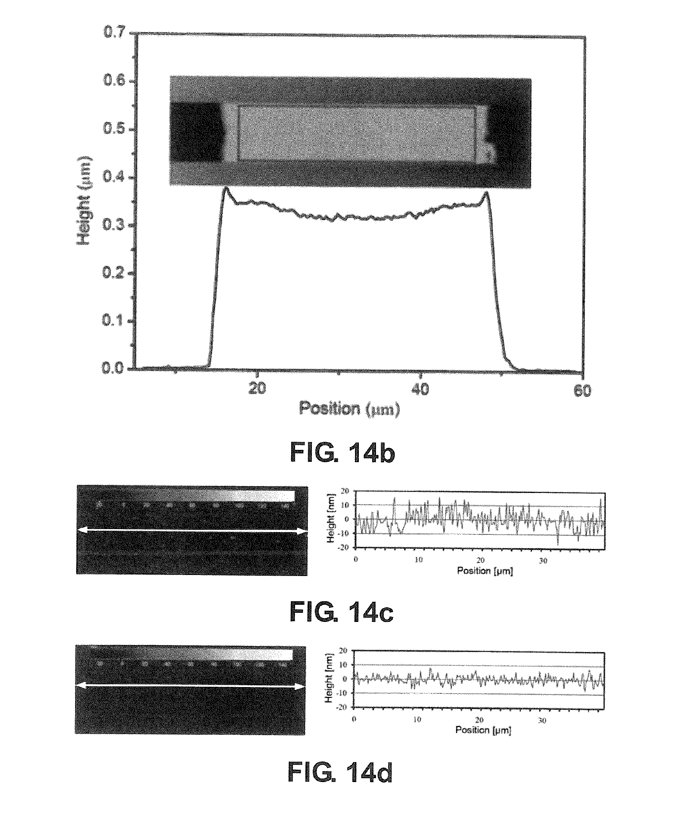

Fig. 14a shows pattern width dependence on the laser power ($\lambda$ = 1070 nm) and the scan rate (spin coated at 1000 rpm and a pre-baking time of 90 sec). Fig. 14b shows AFM profile and image of a laser cured silver line pattern (spincoated at 1000 rpm, 200 mW laser power, 25 mm/s scan rate). Fig. 14c shows 2D AFM surface roughness images and corresponding profile of laser cured pattern. Fig. 14d shows E-beam evaporated pattern.

Fig. 14a shows the pattern width dependence on the laser power and the curing rate. It should be noted that the current organometallic ink based LDC approach could yield the patterns even at a curing rate of 25 mm/s which is several orders of magnitude higher speed than the previous study using nanoparticles ink based LDC approach (0.2 mm/s). Besides the patterning speed, the resolution could be easily controlled and a wide range of structure size (20~100 $\mu$m) was achieved by varying the laser power with a fixed spot size (25 $\mu$m), as shown in Fig. 14a. The patterns which are smaller than the applied laser beam size could be achieved due to the reduced and uniform thermal diffusion by the relatively lower absorption. Conventionally, the pattern width is larger than beam size due to the thermal diffusion by high thermal conductivity of metal nanoparticles for the previous nanoparticle based LDC approach. The thermal diffusion effect could be relived for the organometallic ink due to the high thermal sensitivity of the pre-baked ink and relatively low thermal conductance of silver/organic complexes. In this study, it was possible to improve the resolution down to 10 $\mu$m using laser beam of 10 $\mu$m. However, the pattern resolution could be further improved by decreasing the beam size with a tighter focusing optic system. Practically, it is expected to be possible to achieve 2~5 $\mu$m minimum resolution considering the wavelength (1070 nm) and the thermal diffusion.

A profile of the pattern in Fig. 14b shows that the rim-type elevations at the edge of the pattern are less pronounced than those usually observed in the conventional nanoparticles ink based LDC [Fig. 6]. This is because the relative increase of the ink's viscosity caused by the pre-baking procedure and the decrease of the surface tension gradient by using the relative low absorption wavelength depresses the marangoni flow which usually induces the high rim structures. These contentions are supported by the following relationship of the marangoni number:

$$Ma = \frac{\Delta \sigma d}{\mu D}$$

where $\Delta\sigma$ is the surface tension gradient, d is the characteristic length, D is the characteristic dimension and $\mu$ is the dynamic viscosity. The absence of the high rim structure and the smooth surface is very important for multilayered electronic fabrication to remove short problems. Atomic force microscope (AFM) measurements in Fig. 14c revealed that the root-mean-square (RMS) surface roughness (Ra) of the cured metal pattern was approximately 6.0 nm which is much smaller roughness than the previous nanoparticle based LDC methods. This smooth surface resulted from the uniform distribution of tiny nanoparticles and the homogeneous curing in the thickness direction by removing the explosive evaporation using low absorption laser light source. The optically high reflectivity of the prepared pattern can be easily expected from the theoretical relationship of surface roughness and specular reflectance, since the surface roughness value is much smaller than the visible wavelength and only two times larger than that of the E-beam evaporated Ag film (Ra~2.9 nm), as shown in Fig. 14c, 14d. The silver surface prepared by current LDC approach showed high quality reflective surface (reflectivity: 94%) as good as the one prepared by the E-beam evaporation (reflectivity: 96%).

A cost-effective and convenient means of fabricating electrically conductive tracks on polymer substrates is required for the development of flexible electronics and optoelectronics.

Meanwhile, a manufacturing cost for the present invention will be described below.

Although researchers have suggested several metallic nanoparticle ink-based fabrication processes that rely on ink-jet printing and laser curing, these techniques can be expensive due to the high cost of nanoparticle ink — 5 nm silver nanoparticle ink costs around US$30,000 kg$^{-1}$. There are also several other limitations, including low processing rates, low resolution, non-uniform profiles and low surface quality compared with vacuum-deposited electrodes.

A microelectrode fabrication technique of the present invention uses organometallic ink costing only US$300 kg$^{-1}$ while yielding higher-quality tracks than those of previously studied inks.

As such, it can be understood by those skilled in the art that technical configurations of the present invention can be embodied in other specific forms without changing its spirit or essential characteristics of the present invention.

The foregoing embodiments and advantages are merely exemplary and are not to be construed as limiting the present invention. The present teaching can be readily applied to other types of apparatuses. The description of the foregoing embodiments is intended to be illustrative, and not to limit the scope of the claims. Many alternatives, modifications, and variations will be apparent to those skilled in the art. In the claims, means-plus-function clauses are intended to cover the structures described herein as performing the recited function and not only structural equivalents but also equivalent structures.

## Claims

1. A method of fabricating a pattern, the method comprising:

   a first step of forming an organometallic ink layer 20 on a substrate;
   a second step of curing the organometallic ink layer 20 into a semi-solid state;
   a third step of forming a pattern by irradiating laser onto the semi-solid organometallic ink layer 20, so that the irradiated portion of the organometallic ink layer 20 is changed into a solid state; and
   a fourth step of leaving only the pattern by removing the semi-solid organometallic ink layer 20.

2. The method of claim 1, wherein, in the second step, the substrate including the organometallic ink layer 20 formed thereon is heated by a heat lamp, so that the organometallic ink layer 20 is changed into a semi-solid state.

3. The method of claim 1, wherein, in the second step, the substrate including the organometallic ink layer 20 formed thereon is heated by a hot plate or a convection oven, so that the organometallic ink layer 20 is changed into a semi-solid state.

4. The method of claim 1, wherein the fourth step further comprises removing the semi-solid organometallic ink layer 20 by immersing the substrate in a cleaning solution, or by performing ultrasonic cleaning on the substrate or by injecting the cleaning solution to the substrate.

5. The method of claim 4, wherein the fourth step further comprises heating the substrate including the pattern formed thereon.

EP 2 408 283 A1

START

FIRST STEP OF FORMING ORGANOMETALLIC INK LAYER ON SUBSTRATE

SECOND STEP OF CURING ORGANOMETALLIC INK LAYER INTO SEMI-SOLID STATE

THIRD STEP OF FORMING PATTERN BY IRRADIATING LASER ONTO SEMI-SOLID
ORGANOMETALLIC INK LAYER, SO THAT IRRADIATED PORTION OF
ORGANOMETALLIC INK LAYER IS CURED INTO SOLID STATE

FOURTH STEP OF LEAVING ONLY PATTERN BY REMOVING SEMI-SOLID ORGANOMETALLIC INK LAYER

END

# FIG. 1

FIG. 2

FIG. 3

**FIG. 4**

EP 2 408 283 A1

laser

Marangony flow

Hydrodynamic flow

21

10

10

FIG. 5

15

**FIG. 6**

FIG. 7

FIG. 8

## FIG. 9

## FIG. 10

**FIG. 11**

LASER MODULE

LASER

BEAM HOMOGENIZER

MASK

PROJECTION LENS

IMAGE IS REDUCED AND PROJECTED

MASK

IMAGE

# FIG. 12

**FIG. 13**

FIG. 14a

**FIG. 14b**

**FIG. 14c**

**FIG. 14d**

Europäisches
Patentamt

European
Patent Office

Office européen
des brevets

# EUROPEAN SEARCH REPORT

**Application Number**

EP 11 17 2936

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2006/130582 A1 (HEWLETT PACKARD DEVELOPMENT CO [US]; DOROGY WILLIAM [US]; CHAFFINS STE) 7 December 2006 (2006-12-07) * paragraph [0013] - paragraph [0035]; figures 1-4 * ----- | 1-5 | INV. H05K3/10 |
| A | US 2009/297802 A1 (SASTRY CHIDELLA KRISHNA [IN] ET AL) 3 December 2009 (2009-12-03) * paragraph [0010] - paragraph [0015] * * paragraph [0027] - paragraph [0043] * ----- | 1-5 | |
| A | US 2007/154644 A1 (HWANG GUE-WUU [TW] ET AL) 5 July 2007 (2007-07-05) * the whole document * ----- | 1-5 | |

**TECHNICAL FIELDS SEARCHED (IPC)**

H05K

The present search report has been drawn up for all claims

| Place of search | Date of completion of the search | Examiner |
|---|---|---|
| The Hague | 21 October 2011 | Pacholec, Darek |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 11 17 2936

This annex lists the patent family members relating to the patent documents cited in the above-mentioned European search report.
The members are as contained in the European Patent Office EDP file on
The European Patent Office is in no way liable for these particulars which are merely given for the purpose of information.

21-10-2011

| Patent document cited in search report | Publication date | Patent family member(s) | Publication date |
|---|---|---|---|
| WO 2006130582 A1 | 07-12-2006 | EP 1889524 A1<br>US 2006275705 A1 | 20-02-2008<br>07-12-2006 |
| US 2009297802 A1 | 03-12-2009 | NONE | |
| US 2007154644 A1 | 05-07-2007 | JP 4653716 B2<br>JP 2007182547 A | 16-03-2011<br>19-07-2007 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **BONGCHUL KANG ; SEUNGHWAN KO ; JONG-SU KIM ; MINYANG YANG.** Microelectrode fabrication by laser direct curing of tiny nanoparticle self-generated from organometallic ink. *OPTICS EXPRESS,* 31 January 2011, vol. 19 (3), 2573-2579